# FASCICULE DE BREVET EUROPEEN

(11) **EP 4 456 127 B1**
(45) Date de publication et mention de la délivrance du brevet: **09.12.2026**
(21) Numéro de dépôt: 24171918.6
(22) Date de dépôt: 23.04.2024
(51) Int. Cl.: H01P 5/12, H03F 3/60, H10W 40/47

(54) **COMBINEUR COAXIAL CYLINDRIQUE**
ZYLINDRISCHER KOAXIALER KOMBINATOR
CYLINDRICAL COAXIAL COMBINER

(30) Priorité: 28.04.2023 FR 2304321
(43) Date de publication de la demande: 30.10.2024
(73) Titulaire: Thales, 92190 Meudon (FR)
(72) Inventeur: SPILLEBOUT, Théo, 78140 VELIZY (FR); GESLIN, Florian, 78140 VELIZY (FR); LEGGIERI, Alberto, 91570 BIEVRES (FR); GERFAULT, Bertrand, 78350 JOUY EN JOSAS (FR)
(74) Mandataire: Atout PI Laplace

(56) Documents cités:
- WO-A1-2022/060405
- US-A- 5 142 253
- US-A1- 2020 041 209
- "Progress In Electromagnetics Research C", vol. 45, 2013, UNIVERSITPA DEGLI STUDI DI ROMA, article "THE SQUARAX SPATIAL POWER COMBINER", pages: 43 - 55, XP002810858

## Description

L'invention porte sur un combineur coaxial cylindrique.

La présente invention concerne le domaine de l'amplification de puissance à partir d'amplificateurs à état solide ou SSPA pour "Solid State Power Amplifier" en langue anglaise, et plus précisément la combinaison de puissance, pour tout type d'applications, qu'elles soient militaires (contre mesure, brouillage, radar, transmission) ou civiles (industrielles, commerciales ou scientifiques).

Afin de pouvoir concurrencer les tubes électroniques de puissance il est nécessaire d'en combiner plusieurs entre eux. Dans ce domaine, plus la bande de fréquences est large et plus la puissance à dissiper est importante. De plus, les sources de puissance dissipent la puissance sur une surface très petite, ce qui fait des densités de puissance à dissiper de l'ordre de la centaine de kW.m⁻².

La présente invention s'inscrit dans le cadre d'une démarche visant à développer une solution à amplificateur à état solide permettant de rivaliser avec les actuels amplificateurs hyperfréquences à tubes ou TWTA pour acronyme de "Travelling Wave Tube Amplifiers" en langue anglaise, aujourd'hui sans équivalence en termes de compacité et de densité de puissance mais également avec les autres types d'amplificateur à état solide à combinaison classique ou spatiale.

Un aspect important est la minimisation de l'élévation de température entre la source froide à disposition et la source chaude i.e. l'amplificateur à état solide, qui dépend linéairement de la distance entre les deux éléments. Ainsi, pour gérer de telles densités de puissance, il faut minimiser la distance entre la source chaude et la source froide.

Beaucoup des applications visées, comme l'aviation ou l'aérospatiale, se passent dans des milieux confinés avec un volume à occuper qui est limité. C'est pourquoi il est important que les dispositifs occupent le moins de place possible.

Les principaux dispositifs connus se servent d'éléments particulièrement performants, comme des caloducs, pour établir la jonction entre la source chaude et la source froide. Mais ces éléments aussi performants soient-ils restent inférieurs à une connexion directe entre les deux sources.

Les récents progrès effectués dans le domaine des transistors en technologie GaN (Nitrure de Gallium) permettent d'envisager d'atteindre de tels niveaux de densité de puissance dans une plage allant de la centaine de watts au kilowatt en continu (CW pour acronyme de "Continuous Wave" en langue anglaise).

Le choix de la solution de combinaison est alors un critère déterminant dans une quête de puissance et de largeur de bande, tout en étant le plus compacte possible, ce qui présente une certaine difficulté lorsque l'on souhaite couvrir des bandes allant de 2 à 18GHz avec des niveaux de puissance supérieurs à 100W CW.

Les amplificateurs à état solide ou SSPA de forte puissance présentent des densités de puissance très élevées, de l'ordre de 50 MW/m². De plus, lorsque les amplificateurs à état solide sont à large bande, leur rendement en puissance ajoutée (rapport entre le gain de puissance et la puissance totale consommée), ou PAE pour acronyme de "Power Added Efficiency" en langue anglaise, est faible i.e. <25%, ce qui augmente le besoin en dissipation thermique à puissance de sortie constante. Ce type d'application de très forte densité de puissance est de rendement faible, ce qui est le plus difficile à gérer.

Un aspect majeur de la dissipation thermique est la distance entre la source chaude et la source froide et la maximisation de la surface d'échange. En effet, plus la distance est grande entre les deux, plus la résistance thermique et donc l'élévation de température sera élevée.

Ce problème est particulièrement présent dans les systèmes de combinaison spatiaux qui sont faits pour combiner un grand nombre d'amplificateurs en même temps et qui dit nombre important d'amplificateurs dit beaucoup de puissance à dissiper.

Il est connu des Amplificateurs à Tubes de type tubes à ondes progressives d'acronyme TOP. un filament est chauffé et produit une libération d'électrons par émission thermo-ionique. Ces électrons sont ensuite accélérés dans le vide par un champ électrique de forte intensité généré par une très haute tension, d'acronyme THT. Une fois accélérés, ces électrons sont focalisés dans un faisceau qui interagit avec une onde hyperfréquence. Progressivement, l'énergie continue, d'acronyme DC pour "Direct Current" en langue anglaise, contenue dans le faisceau d'électrons est peu à peu convertie en énergie hyperfréquence à mesure que les électrons parcourent la ligne d'interaction. Cette énergie est alors transmise en dehors du tube alors que le résiduel d'énergie est transmis au collecteur et sera dissipé sous forme de chaleur.

Les tubes à ondes progressives ont l'avantage d'avoir une forte compacité et un haut rendement, mais, en revanche, le fonctionnement est en mode tout ou rien, i.e. en cas de panne, le produit est hors d'usage, nécessite une très haute tension THT, requiert une haute technicité, est très onéreux à produire, et très difficile à maintenir opérationnel.

Il est connu, comme décrit dans le document US 10818998 B2, des amplificateurs à état solide SSPA en combinaison spatiale, comprenant des modules monolithiques combinés par le biais de lignes antipodales de type Vivaldi qui rayonneront ensuite dans des cavités qui constituent les points d'entrées d'un combineur à cavité conique.

De tels amplificateurs permettent d'avoir une bonne compacité, des pertes assez faibles, et une absence de problèmes d'interconnexions inter étages. En revanche, ils ont une combinaison radiale qui rend très complexe la gestion de la thermique, une maintenabilité complexe et une quasi impossibilité de fonctionner de manière optimale en mode pulsé car les capacités de réservoir d'énergie ne peuvent être placées au plus proche des modules monolithiques.

Le document US 11255608 B2 présente un système de refroidissement liquide qui entoure la structure de combinaison avec un conducteur entre les amplificateurs et le réseau de circulation de fluide froid. A ce circuit de refroidissement sur la couche externe peut s'ajouter un système interne grâce au cylindre central sur lequel s'appuie l'ensemble des éléments qui pourrait également accueillir une circulation de fluide froid.

Le document US 10539371 B2 présente un système similaire au précédent. La différence est sur la forme et l'intégration du circuit de refroidissement. Ce dispositif est une sorte de serpentin intégré à la structure venant enserrer le dispositif de combinaison alors que le précédent se trouvait entre l'architecture de combinaison et cette structure extérieure finale enserrant l'ensemble des autres éléments.

Ces deux derniers types de systèmes de refroidissement s'attachent à décrire les possibilités de circulation de fluide autour de la structure d'amplification.

Il est également connu le document US 2022/0279676 A1, qui présente les possibilités de conduction entre l'amplificateur et le système de refroidissement qui pourrait correspondre aux deux types de refroidissement cités ci-dessus. Ce document s'attache à décrire les potentiels d'intégration de dissipateurs très classiques comme un dissipateur à base de cuivre ou de dissipateurs plus sophistiqués à base de caloduc.

Aucune de ces solutions existantes n'est donc satisfaisante car toutes présentent des défauts majeurs.

Il est également connu le document "THE SQUARAX SPATIAL POWER COMBINER" du Progress In Electromagnetics Research C, Vol. 45, 43-55, du Dipartimento di Ingegneria Elettronica, Universitµa degli Studi di Roma, de 2013, qui ne résout pas les problèmes techniques et technologiques de réalisation, notamment la question de la gestion thermique pointée souvent comme étant la faiblesse des combineurs spatiaux.

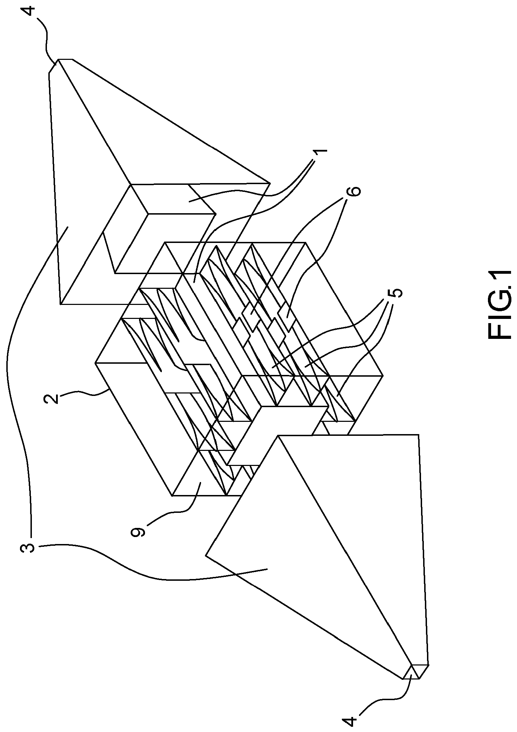

La [Fig.1] illustre schématiquement un tel combineur coaxial cylindrique nommé squarax. Le squarax est un combineur coaxial qui comprend un conducteur interne 1 de section rectangulaire, un capot externe 2 de section rectangulaire, et deux conducteurs externes 3 disposés aux extrémités du capot externe 2. Chaque conducteurs externes 3 est pourvu d'un connecteur coaxial 4 en leur extrémité externe. Il comprend également des cartes électroniques amplificatrices de puissance 5, en l'espèce huit cartes électroniques amplificatrices de puissance 5, pourvues d'amplificateurs à état solide ou SSPA 6.
Sur la [Fig.1], ainsi que sur toutes les autres figures de l'état de l'art ou de l'invention, les transitions Fin Lin ou ligne de transmission quasi planaire particulière, ne sont pas représentées.
La [Fig.2] illustre schématiquement une vue de coupe du squarax, transverse à son axe longitudinal.
La [Fig.3] illustre schématiquement une vue de face d'une carte électronique amplificatrice de puissance du combineur coaxial cylindrique squarax.

Un but de l'invention est de pallier les problèmes précédemment cités.

Il est proposé, selon un aspect de l'invention, un combineur coaxial cylindrique comprenant :
- un conducteur interne de section rectangulaire ;
- un capot externe de section rectangulaire ;
- une cavité entre le conducteur interne et le capot externe, ou, en d'autres termes un espace de propagation des ondes RF ;
- deux conducteurs externes disposés aux extrémités du capot externe, pourvus d'un connecteur coaxial en leur extrémité externe ;
- des cartes électroniques amplificatrices de puissance connectées électriquement au conducteur interne ;
- au moins un amplificateur à état solide, par carte électronique amplificatrice de puissance, disposé sur la carte de sorte à être plus proche du bord externe de la carte que du bord interne de la carte en contact avec le conducteur interne ; et
- un circuit de refroidissement comprenant au moins une portion configurée pour faire circuler un fluide caloporteur, traversant la cavité du combineur coaxial, le conducteur interne, puis la cavité du combineur coaxial, disposée en contact avec la partie arrière d'une carte électronique amplificatrice de puissance sur laquelle est disposé au moins un amplificateur à état solide.

Dans un mode de réalisation, une carte électronique amplificatrice de puissance comprend une partie centrale de hauteur supérieure au reste de la carte.

Selon un mode de réalisation, le combineur comprend des éléments démontables formant le capot externe en vis-à-vis des parties centrales des cartes électroniques amplificatrices de puissance.

Dans un mode de réalisation, la partie centrale d'une carte électronique amplificatrice de puissance comprend une découpe de la forme de l'amplificateur à état solide dans laquelle est inséré l'amplificateur traversant la carte.

Selon un mode de réalisation, une portion traversante du circuit de refroidissement est de section oblongue de longueur sensiblement égale à la largeur d'un amplificateur à état solide.

Dans un mode de réalisation, une portion traversante du circuit de refroidissement comprend deux parties rectilignes orthogonales reliées par une partie coudée, une partie rectiligne étant disposée entre deux amplificateurs à état solide.

Selon un mode de réalisation, le circuit de refroidissement comprend deux portions traversantes symétriques dans un plan de coupe transverse à l'axe longitudinal du combineur, par rapport à un axe passant par deux coins opposés de la section rectangulaire de coupe du conducteur interne, chaque portion traversante ayant deux parties rectilignes orthogonales reliées par une partie coudée, et chaque partie rectiligne étant disposée entre deux amplificateurs à état solide.

Dans un mode de réalisation, le circuit de refroidissement comprend quatre portions traversantes deux à deux symétriques dans un plan de coupe transverse à l'axe longitudinal du combineur, par rapport à deux axes perpendiculaires entre eux, passant chacun par deux milieux de côtés opposés de la section rectangulaire de coupe du conducteur interne, chaque portion traversante ayant deux parties rectilignes orthogonales reliées par une partie coudée, et chaque partie rectiligne étant disposée entre deux amplificateurs à état solide.

Selon un mode de réalisation, le circuit de refroidissement comprend huit portions traversantes quatre à quatre symétriques dans un plan de coupe transverse à l'axe longitudinal du combineur, par rapport à deux axes perpendiculaires entre eux, passant chacun par deux milieux de côtés opposés de la section rectangulaire de coupe du conducteur interne, chaque portion traversante ayant deux parties rectilignes orthogonales reliées par une partie coudée, et chaque partie rectiligne étant disposée entre deux amplificateurs à état solide.

L'invention sera mieux comprise à l'étude de quelques modes de réalisation décrits à titre d'exemples nullement limitatifs et illustrés par les dessins annexés sur lesquels :
[Fig.1] illustre schématiquement un concept de combineur coaxial cylindrique squarax, selon l'état de la technique ;

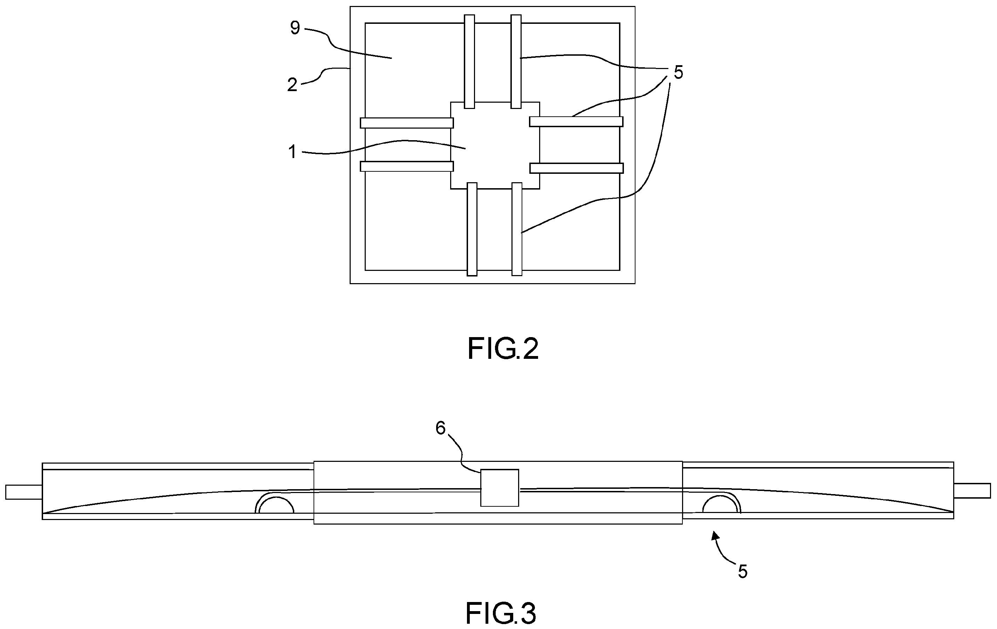

[Fig.2] illustre schématiquement une vue de coupe transversale du combineur coaxial cylindrique squarax de la [Fig.1], selon l'état de la technique ;
[Fig.3] illustre schématiquement une vue de face d'une carte électronique amplificatrice de puissance du combineur coaxial cylindrique squarax de la [Fig.1], selon l'état de la technique ;

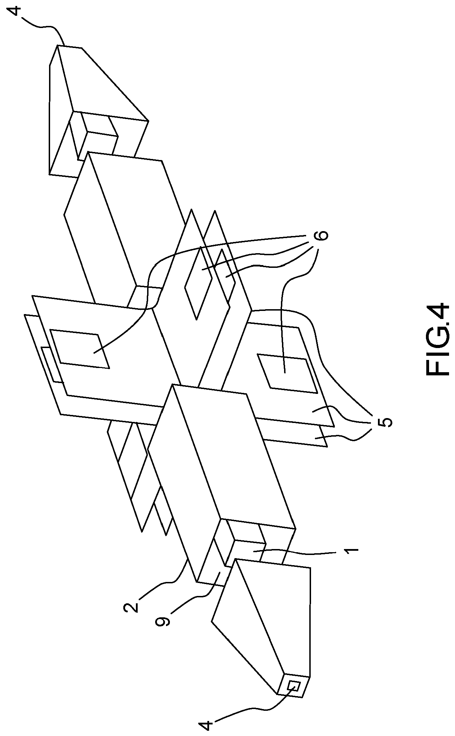

[Fig.4] illustre schématiquement un combineur coaxial cylindrique squarax, sans son boîtier externe, selon un aspect de l'invention ;

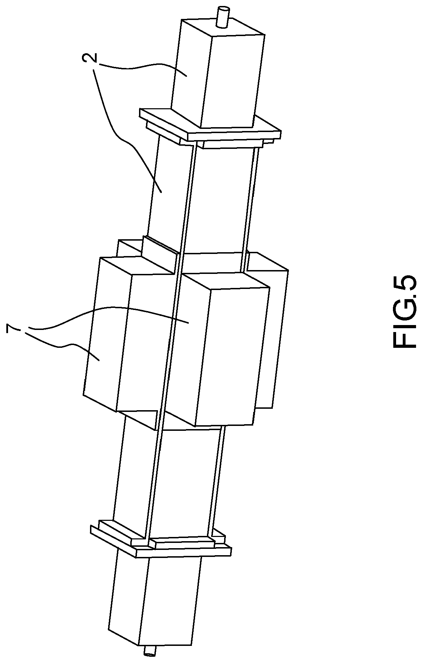

[Fig.5] illustre schématiquement le combineur coaxial cylindrique squarax de la [Fig.4], avec son boîtier externe, selon un aspect de l'invention ;

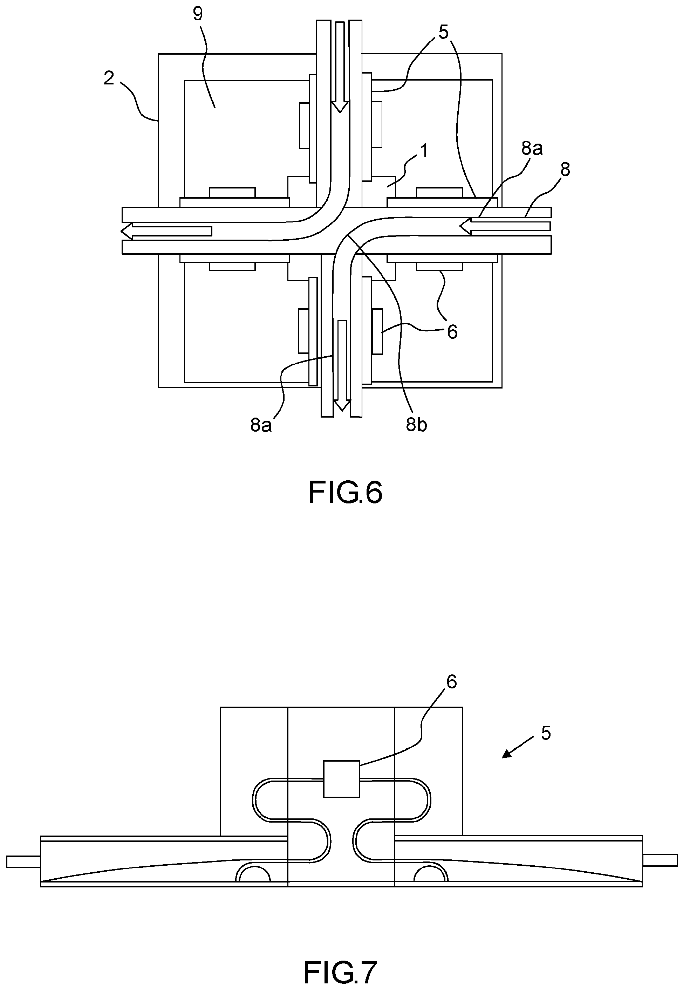

[Fig.6] illustre schématiquement une vue de coupe transversale du combineur coaxial cylindrique squarax de la [Fig.4], selon un aspect de l'invention ;
Fig.7] illustre schématiquement une vue de face d'une carte électronique amplificatrice de puissance du combineur coaxial cylindrique squarax de la [Fig.4], selon un aspect de l'invention ;

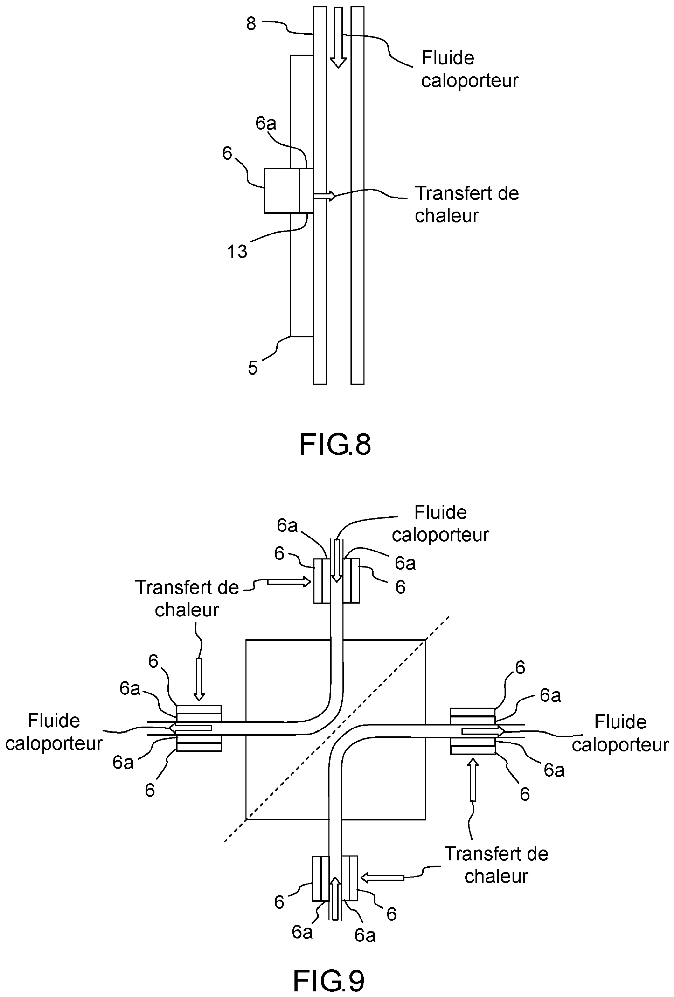

[Fig.8] illustre schématiquement une vue de profil de la carte électronique amplificatrice de puissance de la [Fig.7], et d'une partie du circuit de refroidissement, selon un aspect de l'invention ;
[Fig.9] illustre schématiquement un mode de réalisation d'un combineur coaxial cylindrique squarax comprenant deux portions traversantes, selon un aspect de l'invention ;

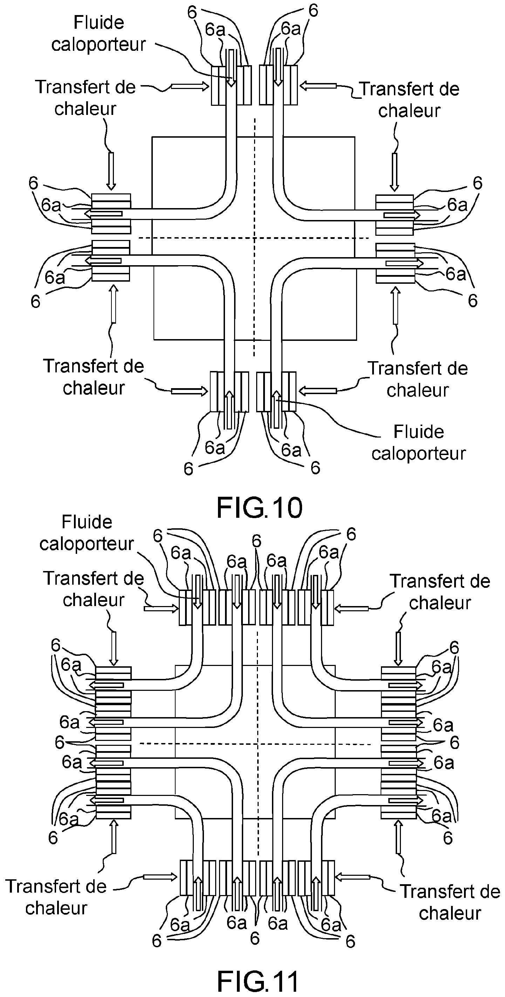

[Fig.10] illustre schématiquement un mode de réalisation d'un combineur coaxial cylindrique squarax comprenant quatre portions traversantes, selon un aspect de l'invention ;
[Fig.11] illustre schématiquement un mode de réalisation d'un combineur coaxial cylindrique squarax comprenant huit portions traversantes, selon un aspect de l'invention ;

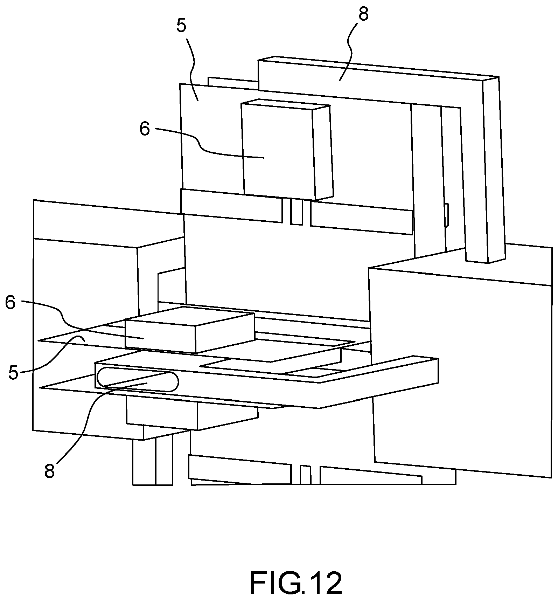

[Fig.12] illustre schématiquement une vue en perspective en 3D d'un combineur coaxial cylindrique squarax, selon un aspect de l'invention ; et

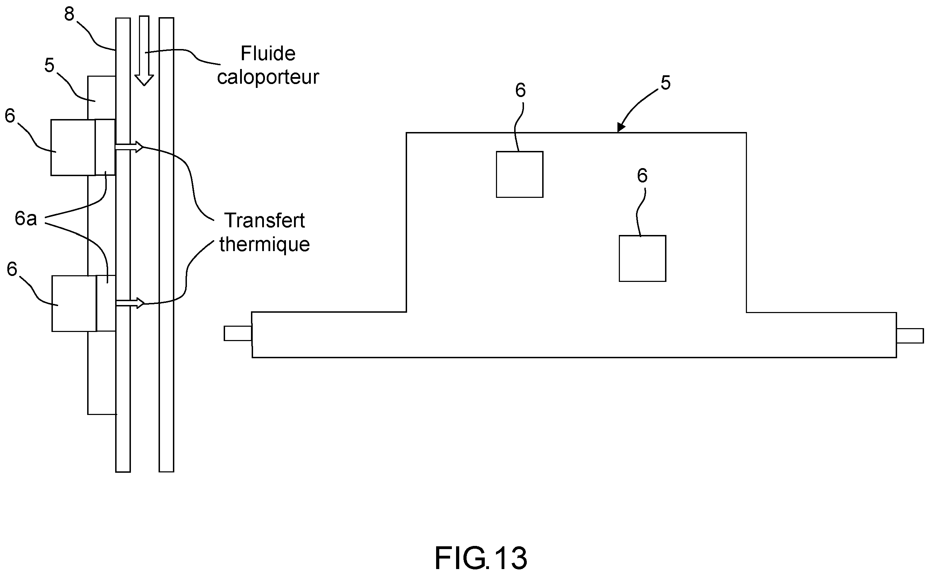

[Fig.13] illustre schématiquement deux amplificateur à état solide ou SSPA.

Sur l'ensemble des figures, les éléments ayant des références identiques sont similaires.

La [Fig.4] illustre schématiquement un combineur coaxial cylindrique squarax, sans son boîtier externe, selon un aspect de l'invention. Le combineur coaxial cylindrique squarax comprend un conducteur interne 1 de section rectangulaire, un capot externe 2 de section rectangulaire, et deux conducteurs externes 3 disposés aux extrémités du capot externe, pourvus d'un connecteur coaxial 4 en leur extrémité externe. Par exemple, les conducteurs externes 3 sont pourvus en leur extrémité externe d'un port de type SMA pour acronyme de "SubMiniature version A" Il comprend également des cartes électroniques amplificatrices de puissance 5, en l'espèce huit cartes électroniques amplificatrices de puissance 5.

Le combineur coaxial cylindrique squarax comprend au moins un amplificateur à état solide 6 ou SSPA, par carte électronique amplificatrice de puissance 5, disposé sur la carte 5 de sorte à être plus proche du bord externe de la carte 5 que du bord interne de la carte en contact avec le conducteur interne 1.

Le combineur coaxial cylindrique squarax comprend, en outre, un circuit de refroidissement, non représenté sur la [Fig.4], ni sur la [Fig.5], représentant un exemple de réalisation du capot externe 2 de section rectangulaire, qui comprend également des éléments démontables 7 formant le capot externe en vis-à-vis des parties centrales des cartes électroniques amplificatrices de puissance 5.

Cette partie comprenant des éléments démontables 7, permet un accès facile pour des réparations ou remplacement d'éléments du combineur coaxial cylindrique squarax.

La [Fig.6] illustre schématiquement une vue de coupe transversale du combineur coaxial cylindrique squarax de la [Fig.4], sur lequel une partie du circuit de refroidissement est représenté. Le circuit de refroidissement comprend au moins une portion traversante 8 configurée pour faire circuler un fluide caloporteur, traversant la cavité 9 du combineur coaxial, le conducteur interne 1, puis la cavité 9 du combineur coaxial, disposée en contact avec la partie arrière d'une carte électronique 5 amplificatrice de puissance sur laquelle est disposé au moins un amplificateur à état solide 6.

Un exemple de circulation de fluide caloporteur dans le circuit de refroidissement, ou plus particulièrement dans les portions traversantes 8, est représenté par des flèches.

La [Fig.7] illustre une carte électronique, dont la partie centrale a une hauteur supérieure au reste de la carte, ce qui permet d'accueillir l'ensemble des éléments nécessaire au fonctionnement des amplificateurs tout en augmentant la place laissée au système de refroidissement.

Comme illustré sur la [Fig.8] le combineur permet de faire circuler le fluide caloporteur du circuit de refroidissement directement sous le dissipateur thermique 6a d'un SSPA 6.

Dans les dispositifs de l'état de l'art, le dissipateur thermique décrit servait uniquement de conducteur thermique. De plus, sa surface d'échange utile n'était pas optimale puisque l'échange thermique ne se faisait pas suivant la plus grande de ses faces et ne donnait donc pas les meilleures conditions d'échange. Dans l'état de l'art le dissipateur des combineurs circulaires est une part de tarte tandis que pour le combineur rectangulaire c'est un pavé droit. Ce changement est lié à la géométrie particulière de chacun de ces combineurs. Ces dissipateurs ont deux rôles, conduire et dissiper. La conduction représente l'acheminement des calories vers la surface d'échange avec la source froide qui est la seule à dissiper à proprement parler. Il faut que le chemin de la conduction soit le plus court possible et la surface d'échange la plus grande possible. En considérant que les matériaux ont une conductivité thermique parfaite, il est possible de compenser parfaitement une moindre dissipation par une surface d'échange plus grande, seulement, cela se fait au détriment de la compacité. Clairement notre dispositif garantit un chemin plus court d'au moins un ordre de grandeur (passage du cm au mm) et permet ainsi une compacité accrue. On peut estimer qu'avec un système conventionnel à ailettes le volume serait doublé.

Dans la présente invention, le dissipateur thermique 6a d'un SSPA 6 et le fluide caloporteur circulant dans une portion traversante 8 du circuit de refroidissement ne font qu'un. L'avantage thermique est de maximiser la surface d'échange tout en minimisant la distance thermique entre la source chaude (le SSPA 6) et la source froide (le fluide caloporteur). L'avantage en terme de compacité est que le même dispositif remplit deux fonctions, établir un pont thermique et faire circuler le fluide caloporteur.

Comme illustré sur la [Fig.8], la partie centrale d'une carte électronique amplificatrice de puissance 5 comprend une découpe de la forme de l'amplificateur à état solide ou SSPA 6, dans laquelle est inséré un amplificateur traversant la carte 5.

Dans les combineur de l'état de l'art, les SSPA sont fixés directement sur la carte électronique amplificatrice de puissance, aussi il y a deux barrières entre l'élément de refroidissement et la source chaude : le dissipateur du SSPA et le substrat en céramique de la carte électronique amplificatrice de puissance.

Aussi, la découpe selon l'invention de la carte électronique 5, de manière à pouvoir y insérer le SSPA 6, le tout fixé directement contre une portion traversante 8 du circuit de refroidissement, permet d'enlever une barrière thermique, ce qui augmente significativement les capacités de dissipation thermique du système. De plus, cela minimise le flux thermique absorbé par la carte électronique 5 et minimise donc la dilatation thermique du substrat de la carte électronique 5, source de déformations et donc de dégradation des performances, voire de rupture mécanique. Cette contrainte est souvent limitante dans le choix du substrat de la carte électronique amplificatrice de puissance 5.

De plus, le combineur coaxial cylindrique squarax selon un aspect de l'invention permet de faire circuler le fluide caloporteurr juste derrière le substrat des cartes électroniques amplificatrices de puissance 5, ce qui est impossible dans le cadre des structures coaxiales cylindriques de l'état de l'art.

Selon des modes de réalisation de l'invention, un tel combineur coaxial cylindrique squarax peut présenter des avantages de conception, comme illustrés sur les modes de réalisation des [Fig.9], [Fig.10] et [Fig.11].

Dans le mode de réalisation de la [Fig.9], le circuit de refroidissement comprend deux portions traversantes 8 symétriques dans un plan de coupe transverse à l'axe longitudinal du combineur, par rapport à un axe 11 passant par deux coins opposés de la section rectangulaire de coupe du conducteur interne 1, chaque portion traversante ayant deux parties rectilignes 8a orthogonales reliées par une partie coudée 8b, et chaque partie rectiligne 8a étant disposée entre deux amplificateurs à état solide ou SSPA 6.

Dans le mode de réalisation de la [Fig.10], le circuit de refroidissement comprend quatre portions traversantes 8 deux à deux symétriques dans un plan de coupe transverse à l'axe longitudinal du combineur, par rapport à deux axes 12, 13 perpendiculaires entre eux, passant chacun par deux milieux de côtés opposés de la section rectangulaire de coupe du conducteur interne 1, chaque portion traversante 8 ayant deux parties rectilignes 8a orthogonales reliées par une partie coudée 8b, et chaque partie rectiligne 8a étant disposée entre deux amplificateurs à état solide 6.

Dans le mode de réalisation de la [Fig.11], le circuit de refroidissement comprend huit portions traversantes 8 quatre à quatre symétriques dans un plan de coupe transverse à l'axe longitudinal du combineur, par rapport à deux axes 12, 13 perpendiculaires entre eux, passant chacun par deux milieux de côtés opposés de la section rectangulaire de coupe du conducteur interne 1, chaque portion traversante ayant deux parties rectilignes 8a orthogonales reliées par une partie coudée 8b, et chaque partie rectiligne 8a étant disposée entre deux amplificateurs à état solide 6.

Dans ces trois modes de réalisation, il apparaît clairement des symétries, permettant de réaliser des ensembles pièces identiques à réaliser, puis à assembler. Cela permet de minimiser le nombre de pièces à produire et donc les coûts associés. Les pièces liées au refroidissement thermique font partie intégrante de la structure, elles ne sont pas distinctes. Il n'y a donc ainsi pas de considération sur de possibles dilatations différentielles entre matériaux distincts. Elles peuvent être assemblées entre elles par simple vissage pour former la structure finale.

La [Fig.12] illustre schématiquement une vue en perspective en 3D d'un combineur coaxial cylindrique squarax, selon un aspect de l'invention, et la [Fig.13] illustre schématiquement deux amplificateur à état solide ou SSPA.

Le combineur coaxial cylindrique selon l'invention permet de refroidir directement sous les cartes électroniques amplificatrices de puissance à travers la surface d'échange optimale des dissipateurs thermiques 6a des SSPA 6, tout en minimisant la distance entre la source chaude et la source froide, ce qui réduit d'autant l'élévation de température.

De plus, un combineur coaxial cylindrique selon l'invention faisant remplir à un même élément deux fonctions permet d'améliorer la compacité du dispositif, aucun élément nouveau ne venant s'ajouter à la structure par l'extérieur. Ce nouveau système permet de dissiper des densités de puissance jusqu'à trois fois plus importantes que selon les combineurs de l'état de l'art et deux fois supérieures à celles requises par les meilleurs SSPA actuels.

## Revendications

1. Combineur coaxial cylindrique comprenant :
- un conducteur interne (1) de section rectangulaire ;
- un capot externe (2) de section rectangulaire ;
- une cavité (9) entre le conducteur interne (1) et le capot externe (2) ;
- deux conducteurs externes (3) disposés aux extrémités du capot externe (2), pourvus d'un connecteur coaxial (4) en leur extrémité externe ;
- des cartes électroniques (5) amplificatrices de puissance connectées électriquement au conducteur interne (1) ;
- au moins un amplificateur à état solide (6), par carte électronique (5) amplificatrice de puissance, disposé sur la carte (5) de sorte à être plus proche du bord externe de la carte (5) que du bord interne de la carte (5) en contact avec le conducteur interne (1) ; et
- un circuit de refroidissement comprenant au moins une portion traversante (8) configurée pour faire circuler un fluide caloporteur, traversant la cavité (9) du combineur coaxial, le conducteur interne (1), puis la cavité (9) du combineur coaxial, disposée en contact avec la partie arrière d'une carte électronique (5) amplificatrice de puissance sur laquelle est disposé au moins un amplificateur à état solide (6).

2. Combineur selon la revendication 1, dans lequel une carte électronique (5) amplificatrice de puissance comprend une partie centrale de hauteur supérieure au reste de la carte.

3. Combineur selon la revendication 2, comprenant des éléments démontables (7) formant le capot externe en vis-à-vis des parties centrales des cartes électroniques (5) amplificatrices de puissance.

4. Combineur selon l'une des revendications précédentes, dans lequel la partie centrale d'une carte électronique (5) amplificatrice de puissance comprend une découpe de la forme de l'amplificateur à état solide (6) dans laquelle est inséré l'amplificateur (6) traversant la carte (5).

5. Combineur selon l'une des revendications précédente, dans lequel une portion traversante (8) du circuit de refroidissement est de section oblongue de longueur sensiblement égale à la largeur d'un amplificateur à état solide (6).

6. Combineur selon l'une des revendications précédente, dans lequel une portion traversante (8) du circuit de refroidissement comprend deux parties rectilignes (8a) orthogonales reliées par une partie coudée (8b), une partie rectiligne étant disposée entre deux amplificateurs à état solide (6).

7. Combineur selon la revendication 6, dans lequel le circuit de refroidissement comprend deux portions traversantes (8) symétriques dans un plan de coupe transverse à l'axe longitudinal du combineur, par rapport à un axe (11) passant par deux coins opposés de la section rectangulaire de coupe du conducteur interne (1), chaque portion traversante (8) ayant deux parties rectilignes (8a) orthogonales reliées par une partie coudée (8b), et chaque partie rectiligne (8a) étant disposée entre deux amplificateurs à état solide (6).

8. Combineur selon la revendication 6, dans lequel le circuit de refroidissement comprend quatre portions traversantes (8) deux à deux symétriques dans un plan de coupe transverse à l'axe longitudinal du combineur, par rapport à deux axes (12, 13) perpendiculaires entre eux, passant chacun par deux milieux de côtés opposés de la section rectangulaire de coupe du conducteur interne (1), chaque portion traversante (8) ayant deux parties rectilignes (8a) orthogonales reliées par une partie coudée (8b), et chaque partie rectiligne (8a) étant disposée entre deux amplificateurs à état solide (6).

9. Combineur selon la revendication 6, dans lequel le circuit de refroidissement comprend huit portions traversantes (8) quatre à quatre symétriques dans un plan de coupe transverse à l'axe longitudinal du combineur, par rapport à deux axes (12, 13) perpendiculaires entre eux, passant chacun par deux milieux de côtés opposés de la section rectangulaire de coupe du conducteur interne (1), chaque portion traversante (8) ayant deux parties rectilignes (8a) orthogonales reliées par une partie coudée (8b), et chaque partie rectiligne (8a) étant disposée entre deux amplificateurs à état solide (6).

## Patentansprüche

1. Zylindrischer koaxialer Kombinator, umfassend:
- einen Innenleiter (1) mit rechteckigem Querschnitt;
- eine Außenabdeckung (2) mit rechteckigem Querschnitt;
- einen Hohlraum (9) zwischen dem Innenleiter (1) und der Außenabdeckung (2);
- zwei Außenleiter (3), die an den Enden der Außenabdeckung (2) angeordnet sind, die an ihrem Außenende mit einem Koaxialleiter (4) versehen sind;
- elektronische Leistungsverstärkungskarten (5), die elektrisch mit dem Innenleiter (1) verbunden sind;
- mindestens einen Festkörperverstärker (6), je Leistungsverstärkungskarte (5), der auf der Karte (5) angeordnet ist, um näher am äußeren Rand der Karte (5) als dem inneren Rand der Karte (5) in Kontakt mit dem Innenleiter (1) zu liegen; und
- einen Kühlkreislauf, umfassend mindestens einen querenden Abschnitt (8), der konfiguriert ist, um eine Wärmeträgerflüssigkeit, die den Hohlraum (9) des koaxialen Kombinators, den Innenleiter (1), danach den Hohlraum (9) des koaxialen Kombinators durchquert, zirkulieren zu lassen, der in Kontakt mit dem hinteren Teil einer elektronischen Leistungsverstärkungskarte (5) angeordnet ist, auf der mindestens ein Festkörperverstärker (6) angeordnet ist.

2. Kombinator nach Anspruch 1, wobei eine elektronische Leistungsverstärkungskarte (5) einen zentralen Teil mit größerer Höhe als der Rest der Karte umfasst.

3. Kombinator nach Anspruch 2, umfassend abnehmbare Elemente (7), welche die Außenabdeckung gegenüber den zentralen Teilen der elektronischen Leistungsverstärkungskarten (5) bilden.

4. Kombinator nach einem der vorstehenden Ansprüche, wobei der zentrale Teil einer elektronischen Leistungsverstärkungskarte (5) einen Ausschnitt in der Form des Festkörperverstärkers (6) umfasst, in den der Verstärker (6) eingesetzt ist, der die Karte (5) quert.

5. Kombinator nach einem der vorstehenden Ansprüche, wobei ein querender Abschnitt (8) des Kühlkreislaufs von länglichem Querschnitt mit einer Länge im Wesentlichen gleich der Breite eines Festkörperverstärkers (6) ist.

6. Kombinator nach einem der vorstehenden Ansprüche, wobei ein querender Abschnitt (8) des Kühlkreislaufs zwei geradlinige orthogonale Teile (8a) umfasst, die durch einen abgewinkelten Teil (8b) verbunden sind, wobei ein geradliniger Teil zwischen zwei Festkörperverstärkern (6) angeordnet ist.

7. Kombinator nach Anspruch 6, wobei der Kühlkreislauf zwei symmetrische querende Abschnitte (8) in einer querenden Schnittebene zur Längsachse des Kombinators, in Bezug zu einer Achse (11) umfasst, die durch zwei gegenüberliegenden Ecken des rechteckigen Querschnitts des Innenleiters (1) verlaufen, wobei jeder querende Abschnitt (8) zwei geradlinige orthogonale Teile (8a) aufweist, die durch einen abgewinkelten Teil (8b) verbunden sind, und jeder geradlinige Teil (8a) zwischen zwei Festkörperverstärkern (6) angeordnet ist.

8. Kombinator nach Anspruch 6, wobei der Kühlkreislauf vier symmetrische paarweise querende Abschnitte (8) in einer querenden Schnittebene zur Längsachse des Kombinators, in Bezug zu zwei zueinander senkrechten Achsen (12, 13) umfasst, die jeweils durch zwei gegenüberliegenden Seitenmitten des rechteckigen Querschnitts des Innenleiters (1) verlaufen, wobei jeder querende Abschnitt (8) zwei geradlinige orthogonale Teile (8a) aufweist, die durch einen abgewinkelten Teil (8b) verbunden sind, und jeder geradlinige Teil (8a) zwischen zwei Festkörperverstärkern (6) angeordnet ist.

9. Kombinator nach Anspruch 6, wobei der Kühlkreislauf acht symmetrische in Vierergruppen querende Abschnitte (8) in einer querenden Schnittebene zur Längsachse des Kombinators, in Bezug zu zwei zueinander senkrechten Achsen (12, 13) umfasst, die jeweils durch zwei gegenüberliegenden Seitenmitten des rechteckigen Querschnitts des Innenleiters (1) verlaufen, wobei jeder querende Abschnitt (8) zwei geradlinige orthogonale Teile (8a) aufweist, die durch einen abgewinkelten Teil (8b) verbunden sind, und jeder geradlinige Teil (8a) zwischen zwei Festkörperverstärkern (6) angeordnet ist.

## Claims

1. Cylindrical coaxial combiner comprising:
- a rectangular cross-sectioned internal conductor (1);
- a rectangular cross-sectioned external cap (2);
- a cavity (9) between the internal conductor (1) and the external cap (2);
- two external conductors (3) disposed at the ends of the external cap (2), provided with a coaxial conductor (4) in their external end;
- power-amplifying electronic boards (5), electrically connected to the internal conductor (1);
- at least one solid state amplifier (6), per power-amplifying electronic board (5), disposed on the board (5), so as to be closer to the external edge of the board (5) than to the internal edge of the board (5) in contact with the internal conductor (1); and
- a cooling circuit comprising at least one through portion (8), configured to make a heat-transfer fluid circulate, passing through the cavity (9) of the coaxial combiner, the internal conductor (1), then the cavity (9) of the coaxial combiner, disposed in contact with the rear part of a power-amplifying electronic board (5), on which at least one solid state amplifier (6) is disposed.

2. Combiner according to claim 1, wherein a power-amplifying electronic board (5) comprises a central part of height greater than the rest of the board.

3. Combiner according to claim 2, comprising removable elements (7) forming the external cap opposite the central parts of the power-amplifying electronic boards (5).

4. Combiner according to any one of the preceding claims, wherein the central part of a power-amplifying electronic board (5) comprises a cutout of the shape of the solid state amplifier (6), wherein the amplifier (6) passing through the board (5) is inserted.

5. Combiner according to any one of the preceding claims, wherein a through portion (8) of the cooling circuit is of oblong cross-section of length substantially equal to the width of a solid state amplifier (6).

6. Combiner according to any one of the preceding claims, wherein a through portion (8) of the cooling circuit comprises two orthogonal rectilinear parts (8a) connected by a bent part (8b), a rectilinear part being disposed between two solid state amplifiers (6).

7. Combiner according to claim 6, wherein the cooling circuit comprises two symmetric through portions (8) in a cross-sectional plane to the longitudinal axis of the combiner, with respect to an axis (11) passing through two opposite corners of the rectangular cross-section of the internal conductor (1), each through portion (8) having two orthogonal rectilinear parts (8a) connected by a bent part (8b), and each rectilinear part (8a) being disposed between two solid state amplifiers (6).

8. Combiner according to claim 6, wherein the cooling circuit comprises four symmetric through portions (8) in pairs in a cross-sectional plane to the longitudinal axis of the combiner, with respect to two axes (12, 13) perpendicular to one another, each passing through two side media opposite the rectangular cross-section of the internal conductor (1), each through portion (8) having two orthogonal rectilinear parts (8a) connected by a bent part (8b), and each rectilinear part (8a) being disposed between two solid state amplifiers (6).

9. Combiner according to claim 6, wherein the cooling circuit comprises eight symmetric through portions (8), four by four, in a cross-sectional plane to the longitudinal axis of the combiner, with respect to two axes (12, 13), perpendicular to one another, each passing through two side media of the rectangular cross-section of the internal conductor (1), each through portion (8) having two orthogonal rectilinear parts (8a) connected by a bent part (8b), and each rectilinear part (8a) being disposed between two solid state amplifiers (6).
